# FASCICULE DE BREVET EUROPEEN

(11) **EP 4 494 225 B1**
(45) Date de publication et mention de la délivrance du brevet: **11.06.2025**
(21) Numéro de dépôt: 23710066.4
(22) Date de dépôt: 14.03.2023
(51) Int. Cl.: H01S 5/0687, H01S 5/40, H01S 5/00, H04B 10/572

(54) **SOURCE LASER PRÉSENTANT UNE PLURALITÉ DE RAIES SPECTRALES SÉPARÉES D'UN INTERVALLE SPECTRAL DÉTERMINÉ**
LASERQUELLE MIT MEHREREN DURCH EIN BESTIMMTES SPEKTRALINTERVALL GETRENNTEN SPEKTRALLINIEN
LASER SOURCE HAVING A PLURALITY OF SPECTRAL LINES SEPARATED BY A DETERMINED SPECTRAL INTERVAL

(30) Priorité: 15.03.2022 FR 2202254; 24.05.2022 FR 2204950; 25.07.2022 FR 2207600
(43) Date de publication de la demande: 22.01.2025
(73) Titulaire: Scintil Photonics, 38040 Grenoble Cedex 9 (FR)
(72) Inventeur: MENEZO, Sylvie, 38040 GRENOBLE CEDEX 9 (FR); ENAULT, Florian, 22140 BEGARD (FR)
(74) Mandataire: IP Trust
(86) Numéro de dépôt international: PCT/EP2023/056422
(87) Numéro de publication internationale: WO 2023/174909

(56) Documents cités:
- EP-A1- 2 573 961
- WO-A1-2013/044863
- US-A1- 2002 048 063
- US-A1- 2009 232 493
- US-B1- 6 349 103
- HATTINK MAARTEN ET AL: "Streamlined Architecture for Thermal Control and Stabilization of Cascaded DWDM Micro-Ring Filters Bus", 2022 OPTICAL FIBER COMMUNICATIONS CONFERENCE AND EXHIBITION (OFC), OSA, 6 March 2022 (2022-03-06), pages 1 - 3, XP034109709

## Description

### DOMAINE DE L'INVENTION

La présente invention concerne une source laser pour émettre un rayonnement lumineux présentant une pluralité de raies spectrales séparées d'un intervalle spectral déterminé. Une telle source trouve une application toute particulière dans le domaine des communications par multiplexage par répartition en longueur d'onde.

### ARRIERE PLAN TECHNOLOGIQUE DE L'INVENTION

Le document « WDM Source Based on High-Power, Efficient 1280-nm DFB Lasers for Terabit Interconnect Technologies », de B. Buckley, IEEE PHOTONICS TECHNOLOGY LETTERS, VOL. 30, NO. 22, NOVEMBER 15, 2018, propose une source laser formée d'une banque de lasers à rétroaction répartie. Chaque laser comprend un réseau de Bragg distribué le long de la cavité laser. Les lasers émettent des rayonnements lumineux à des longueurs d'onde étagées, typiquement écartées de 100GHz ou de 50GHz les unes des autres.

Les rayonnements lumineux émis par les lasers sont propagés aux ports d'entrée d'un mélangeur optique passif. Ce mélangeur produit, sur ses ports de sortie, une pluralité de rayonnements lumineux combinant chacun les rayonnements lumineux fournis sur ses ports d'entrée. Les rayonnements de sortie produits sur ces ports de sortie sont donc multispectraux (en peigne spectral, chaque raie du peigne correspondant au rayonnement émis par un laser de la banque).

Du fait des imprécisions et de la variabilité des procédés de fabrication des lasers, leurs longueurs d'onde d'émission sont mal maitrisées. Cela induit une variabilité de l'intervalle spectral présent entre deux raies spectrales d'un rayonnement multispectral, de l'ordre de plus ou moins 5 à 10% de l'intervalle spectral attendu, voire plus suivant l'intervalle. Les longueurs d'onde des rayonnements lumineux émis par les lasers sont également sensibles à la température d'opération, cette dernière pouvant évoluer par exemple de 0 à 80°C.

L'intervalle spectral du rayonnement lumineux fourni par une source laser multispectrale de l'état de la technique est donc mal maitrisé et susceptible de dériver au cours du fonctionnement de cette source.

Le document WO2013044863 propose un transmetteur formé d'une source laser multispectrale composée d'une pluralité de lasers dont les fréquences d'émission sont ajustables. Un générateur associé aux laser produit un signal pilote qui module à basse fréquence les émissions lasers. Le rayonnement multispectral produit par le transmetteur est guidé par une fibre optique à un filtre étalon distant. Des diviseurs optiques, respectivement disposés avant et après le filtre étalon fournissent des signaux à un régulateur. Le régulateur génère des signaux d'ajustement qui s'ajoutent aux signaux de modulation des laser pour respectivement verrouiller leurs émissions sur les longueurs d'onde définis par le filtre étalon.

On note que dans la solution proposée par ce document, le filtre étalon, distant de la source laser, n'est pas soumis aux mêmes excursions en température que la source. Ce filtre défini des fréquences étalons absolues auxquelles sont respectivement conformées les fréquences d'émission des laser, par ajustement de leur alimentation. Cette solution n'est pas satisfaisante car elle peut conduire, lorsque les fréquences d'émission s'écartent fortement des fréquences étalons, à produire des signaux d'ajustement des lasers de fortes amplitudes, ce qui affecte la puissance des rayonnements émis par la source laser multispectrale et la rend variable au-delà de seuils acceptables.

Les documents WO2013044863A1, US20090232493A1 et EP2573961A1 proposent des solutions pour détecter la dérive en longueur d'onde d'une source lumineuse et la verrouiller à une longueur d'onde choisie.

### OBJET DE L'INVENTION

Un but de l'invention est de proposer une solution au moins partielle à ce problème. Plus spécifiquement, un but de l'invention est de proposer une source laser apte à fournir un rayonnement lumineux multispectral dont l'intervalle spectral est mieux maitrisé que celui présent dans les rayonnements lumineux produits par les sources laser de l'état de la technique.

### BREVE DESCRIPTION DE L'INVENTION

En vue de la réalisation de ce but, l'objet de l'invention propose Source laser pour émettre au moins un rayonnement lumineux multispectral présentant une pluralité de raies spectrales séparées d'un intervalle spectral déterminé, la source laser comprenant :
- une banque de lasers accordables, une raie spectrale du rayonnement lumineux multispectral correspondant à une fréquence, appelée « fréquence d'émission », du rayonnement lumineux émis par un laser accordable de la banque;
- des moyens d'ajustement des fréquences d'émission des lasers accordables ;
- un filtre optique présentant une pluralité de fréquences de résonance, deux fréquences de résonance successives étant séparées de l'intervalle spectral déterminé, le filtre optique étant disposé optiquement en aval de la banque de lasers accordables, le filtre optique étant muni d'un dispositif d'ajustement de la pluralité de fréquences de résonance ;
- un photodétecteur disposé optiquement en aval du filtre optique pour établir un signal représentatif du rayonnement lumineux multispectral transmis à travers le filtre ;
- un modulateur associé aux moyens d'ajustement des fréquences d'émission des lasers accordables, le modulateur étant configuré pour générer un signal de modulation et moduler la fréquence d'émission du rayonnement lumineux émis par au moins un laser accordable de la banque;
- un dispositif de verrouillage relié aux moyens d'ajustement de la fréquence d'émission des lasers accordables et relié au dispositif d'ajustement de la pluralité de fréquences de résonance, le dispositif de verrouillage étant configuré pour traiter le signal représentatif du rayonnement multispectral et verrouiller les fréquences d'émission des laser accordables aux fréquences de résonance du filtre.

Selon d'autres caractéristiques avantageuses et non limitatives de l'invention, prises seules ou selon toute combinaison techniquement réalisable :
- la source laser comprend un mélangeur optique associé à la banque de lasers accordables pour combiner les rayonnements lumineux émis par les lasers accordables de la banque et fournir le rayonnement lumineux multispectral au filtre ;
- le filtre optique est un micro résonateur en anneau ;
- le dispositif d'ajustement de la pluralité de fréquences de résonance est un réchauffeur ;
- les moyens d'ajustement de la fréquence d'émission des lasers accordables sont choisis dans la liste formée de : une source de courant, un réchauffeur, dispositif d'injection/déplétion des porteurs libres ;
- les lasers de la banque de lasers accordables sont des lasers à rétroaction répartie ou des lasers à réflecteur de Bragg distribué ;
- le dispositif de verrouillage est configuré pour commander le modulateur et sélectionner, à l'aide d'un signal de sélection, le laser accordable auquel est appliqué le signal de modulation ;
- le modulateur génère une pluralité de signaux de modulation distincts les uns des autres, les signaux de modulation étant appliqués aux lasers accordables ;
- le modulateur est configuré pour produire un signal de modulation sinusoïdal présentant une fréquence de modulation ;
- le dispositif de verrouillage est configuré pour établir une mesure représentative de la puissance présente dans une deuxième harmonique et/ou dans une composante principale et/ou une mesure représentative de la phase de la composante principale de la fréquence de modulation du signal représentatif du rayonnement multispectral ;
- la banque de lasers accordables et le filtre optique sont intégrés sur/dans un même substrat d'une puce photonique ;
- le coefficient de dérive en température des fréquences d'émission des lasers accordables et le coefficient de dérive en température des fréquences de résonance sont identiques, à 10% près.

Selon un autre aspect, l'invention propose un procédé d'utilisation de la source laser, le procédé étant mise en œuvre par le dispositif de verrouillage et comprenant :
- une phase de régulation pour activer le dispositif d'ajustement de la pluralité de fréquences de résonance du filtre optique ;
- une phase de verrouillage pour verrouiller la fréquence d'émission du rayonnement lumineux du laser accordable sélectionné à une fréquence de résonance du filtre.

Avantageusement, la phase de verrouillage est opérée après la phase de régulation.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1a]
   [Fig. 1b]
   [Fig. 1c]
   [Fig. 1d]
   [Fig. 1e] Les figures 1a, 1b, 1c, 1d et 1e représentent des schémas des principes sous-tendant l'invention ;
[Fig. 2a] La figure 2a représente un premier mode de réalisation de l'invention ;
[Fig. 2b] La figure 2b représente une variante du premier mode de réalisation de l'invention ;
[Fig. 3a] La figure 3a représente le passage d'un état naturel à l'état verrouillé d'une source laser conforme à l'invention ;
[Fig. 3b] La figure 3b représente une caractéristique avantageuse d'une fonction de transmission d'un filtre d'une source laser conforme à l'invention ;
[Fig. 3c] La figure 3c illustre un étalonnage d'un filtre d'une source laser conforme à un mode de mise en œuvre de l'invention ;
[Fig. 4]

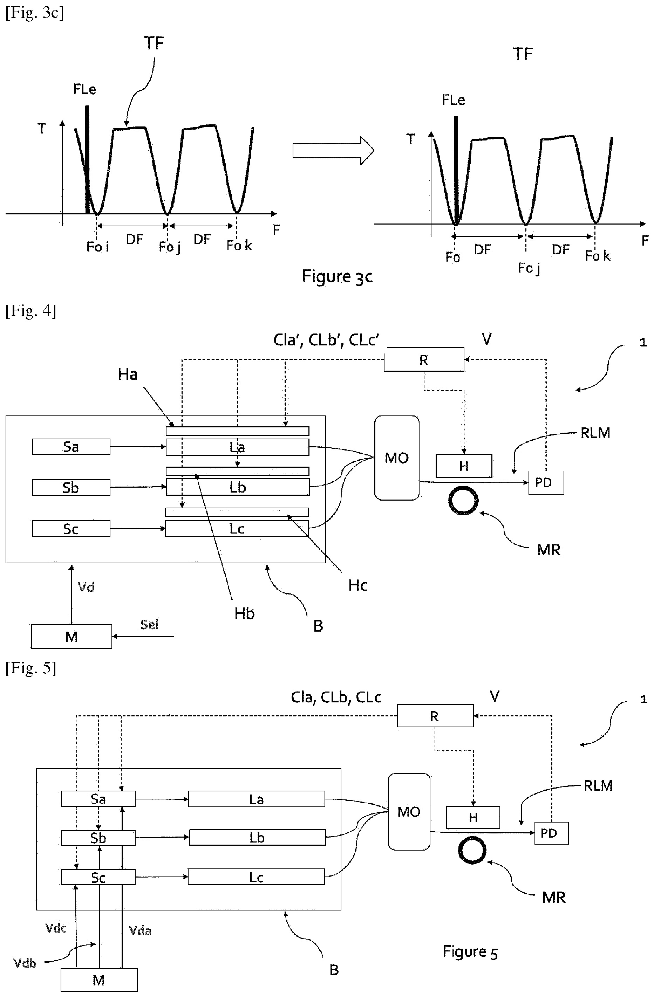

   [Fig. 5] Les figures 4 et 5 représentent d'autres modes de réalisation de l'invention ;

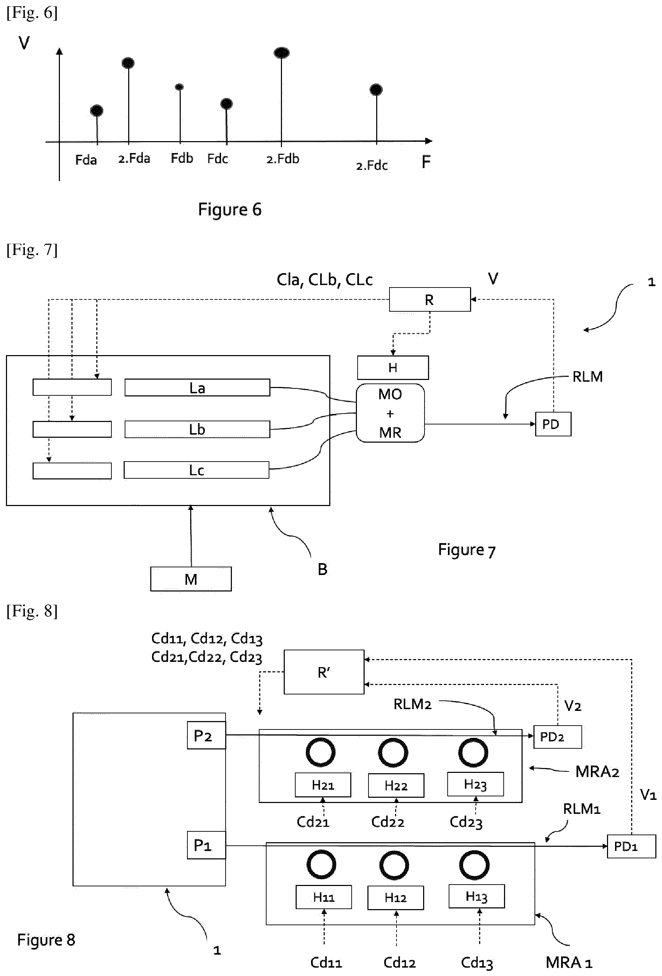

[Fig. 6] La figure 6 représente le signal fourni par le photodétecteur dans le domaine fréquentiel, dans le cadre du mode de réalisation de la figure 5 ;
[Fig. 7] La figure 7 représente une variante applicable à tous les modes de réalisation de l'invention ;
[Fig. 8] La figure 8 représente l'utilisation d'une source conforme au deuxième mode de réalisation de l'invention pour accorder un réseau de modulateurs.

### DESCRIPTION DETAILLEE DE L'INVENTION

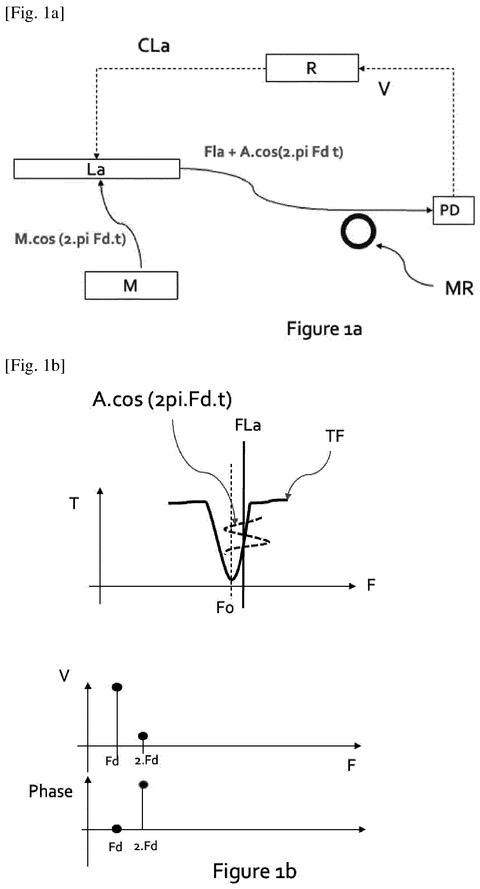

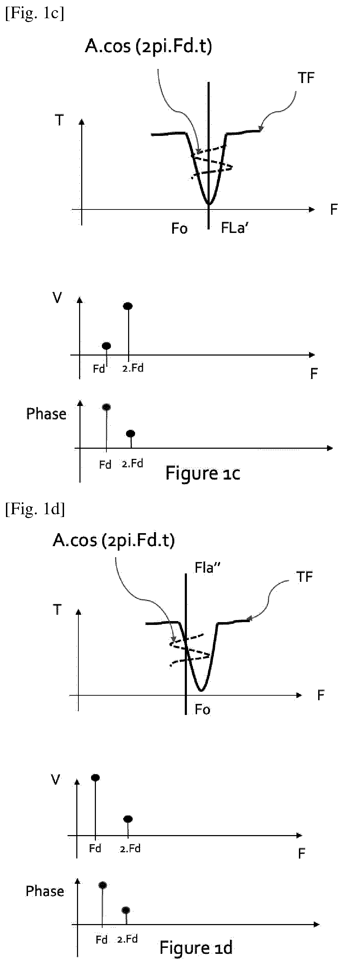

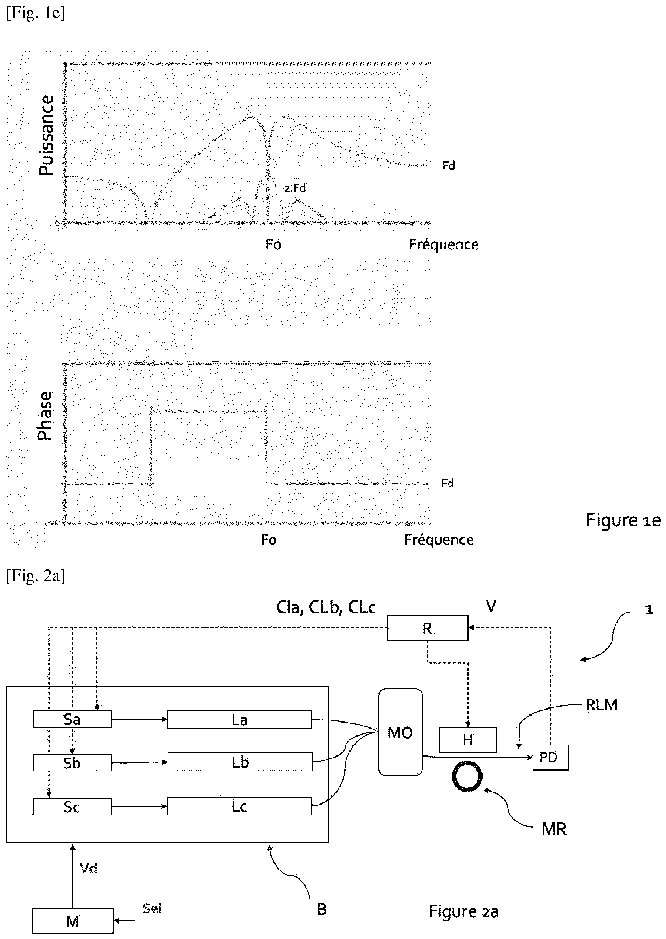

Les figures 1a, 1b, 1c, 1d et 1e sont des schémas des principes sous-tendant l'invention. Sur l'architecture de la figure 1a, un rayonnement lumineux issu d'un laser accordable La est guidé vers un résonateur en anneau MR, constituant un filtre présentant une fréquence de résonance F0, et vers un photodétecteur PD disposé en aval du résonateur MR.

Par « laser accordable », on désigne un laser produisant un rayonnement lumineux dont la fréquence (« la fréquence d'émission ») peut être ajustée. A titre d'illustration, un moyen d'ajustement de la fréquence d'émission dont le laser peut être pourvu peut comprendre un dispositif configuré pour modifier son courant d'alimentation, sa température, son indice, la concentration en porteurs libres. Un laser accordable peut être muni d'une pluralité de moyens d'ajustement de sa fréquence d'émission, par exemple une source de courant ajustable et un réchauffeur permettant de modifier la température de fonctionnement du laser.

Un modulateur M, relié à un moyen d'ajustement de la fréquence d'émission du laser, est configuré pour moduler la fréquence d'émission Fla du rayonnement lumineux émis par le laser accordable La, d'une fréquence de modulation Fd. Cette fréquence de modulation Fd, par exemple de 5 kHz, est relativement faible comparée à la fréquence d'émission du laser, par exemple de 200 térahertz. L'amplitude de cette modulation est également faible. A titre d'exemple, 1 mA d'amplitude de modulation du courant d'alimentation peut conduire à une variation de la fréquence d'émission FLa du laser accordable La de l'ordre de plus ou moins 1 GHz. Le rayonnement lumineux émis par le laser accordable La varie donc à très faible fréquence Fd et avec une faible amplitude A (1GHz) autour de sa fréquence fondamentale FLa. La fréquence laser varie donc comme Fla + A.cos (2pi.Fd.t).

Sur la figure 1b, on a représenté dans le domaine fréquentiel la fonction de transmission T du filtre MR dont le spectre TF présente une fréquence de résonance F0, et le signal V fourni par ce photodétecteur PD dans le cas où la fréquence d'émission FLa du laser accordable La n'est pas verrouillée sur une fréquence de résonance F0 du résonateur MR, mais présente une fréquence d'émission Fla supérieure à la cette fréquence de résonance F0. La fréquence d'émission du laser accordable La étant disposée dans une section relativement linéaire de la fonction de transmission du résonateur MR, le signal V fourni par le photodétecteur PD présente, dans le domaine fréquentiel, une composante principale Fd (correspondant à la fréquence de modulation) relativement importante vis-à-vis de ses harmoniques et notamment vis-à-vis de sa deuxième harmonique 2*Fd. Par ailleurs, la phase de la composante principale Fd du signal V est réduite, c'est-à-dire que cette composante principale est en phase avec le signal V fourni par le photodétecteur PD.

Sur la figure 1c, on a représenté, similairement à la figure 1b, la fonction de transmission T du filtre MR dont le spectre TF présente une fréquence de résonance F0 et le signal V fourni par ce photodétecteur PD dans le cas où la fréquence d'émission FLa' du laser accordable La est verouillée sur la fréquence de résonance F0 du résonateur MR. Dans ce cas, la fréquence d'émission FLa' du laser accordable La est disposé dans une section relativement non linéaire de la fonction de transmission du résonateur MR. En conséquence le signal V fourni par le photodétecteur PD présente, dans le domaine fréquentiel, des composantes harmoniques 2*Fd relativement importantes vis-à-vis de de la fréquence de modulation Fd.

Enfin, sur la figure 1d, on a représenté dans le domaine fréquentiel la fonction de transmission T du filtre MR dont le spectre TF présente une fréquence de résonance F0, et le signal V fourni par ce photodétecteur PD dans le cas où la fréquence d'émission FLa du laser accordable La n'est pas verrouillée sur une fréquence de résonance F0 du résonateur MR, mais présente une fréquence d'émission Fla'' inférieure à la cette fréquence de résonance F0. La fréquence d'émission du laser accordable La étant disposée dans une section relativement linéaire de la fonction de transmission du résonateur MR, le signal V fourni par le photodétecteur PD présente, dans le domaine fréquentiel, une composante principale Fd relativement importante vis-à-vis de ses harmoniques, et notamment vis-à-vis de sa deuxième harmonique 2*Fd. Par ailleurs, la phase de la composante principale Fd du signal V est importante, c'est-à-dire que cette composante principale est en opposition de phase avec le signal V fourni par le photodétecteur.

La figure 1e synthétise les résultats des figures 1b, 1c et 1d et représente, dans le graphe du haut, l'évolution de la puissance présente dans la composante principale Fd et dans la deuxième harmonique 2*Fd du signal V fourni par le photodétecteur quand la fréquence d'émission FLa du laser accordable La est modifiée et que la fréquence de résonance du filtre reste fixe (ou vice versa). La figure 1e représente également, dans le graphe du bas, l'évolution de la phase de la composante principale Fd du signal V fourni par le photodétecteur.

Revenant à la description du schéma de principe de la figure 1a, un dispositif de verrouillage R reçoit le signal V établi par le photodétecteur et le traite pour élaborer une commande CLa du laser accordable La visant à accorder sa fréquence d'émission pour la verrouiller sur la fréquence de résonance F0 du résonateur MR. Le traitement mis en œuvre par le dispositif de verrouillage R exploite les résultats présentés dans les figures 1b,1c,1d,1e et détermine la commande à appliquer au moyen d'ajustement de la fréquence d'émission du laser qui maximise la part du signal présent dans la seconde harmonique 2*Fd du signal fourni par le photodétecteur PD. A titre d'illustration, le dispositif de verrouillage R peut appliquer au dispositif d'ajustement une succession de commande CLa s'incrémentant d'une valeur minimale à une valeur maximale afin que la fréquence d'émission du laser La s'ajuste, au cours d'une succession d'étapes, d'une fréquence minimale d'émission à une fréquence maximale d'émission. A chaque étape, le dispositif de verrouillage R applique une transformation en fréquence au signal fourni par le photodétecteur (par exemple une transformée de Fourrier) afin de relever la part de signal présent dans la seconde harmonique. A l'issue de ces étapes, on identifie l'étape et la commande CLa associée, qui a conduit à un maximum de signal dans la seconde harmonique, cette commande CLa associée étant celle qui fait concorder au mieux la fréquence d'émission du laser La et la fréquence de résonance du filtre MR. On applique alors cette commande au dispositif d'ajustement de la fréquence d'émission du laser La afin de provoquer le verrouillage du système. D'autres approches sont également possibles, par exemple en exploitant, dans une boucle de régulation conduisant à incrémenter ou décrémenter d'un pas prédéterminé la commande Cla fournie au dispositif d'ajustement de la fréquence, l'information de phase de la fréquence principale Fd du signal fourni par le photodétecteur PD. Comme on l'a déjà noté, cette information indique si la fréquence d'émission du laser est inférieure à la fréquence de résonance du laser (phase importante), ou supérieure à cette fréquence (phase nulle ou faible).

On peut rechercher à faire concorder la fréquence d'émission du laser La avec la fréquence de résonance du filtre MR, comme cela vient d'être présenté à titre d'exemple. Alternativement, on peut rechercher à les positionner l'une par rapport à l'autre d'un écart déterminé. D'une manière générale, la détermination de la commande CLa est réalisée par optimisation d'une fonction prenant par exemple en argument la part du signal présente dans la composante principale et/ou dans la seconde harmonique 2*Fd du signal de contrôle V. Le critère d'optimisation peut correspondre à ce que la fonction atteigne une valeur cible, soit inférieure à une valeur plafond prédéterminée ou soit supérieure à une valeur seuil prédéterminée. On peut également prévoir d'exploiter la phase de la composante principale et/ou de la seconde harmonique 2*Fd du signal de contrôle V.

A titre d'exemple, on peut ainsi chercher à fixer le rapport entre la part de signal présent dans la seconde harmonique et la part du signal présent dans la composante principale pour qu'il soit égal à une valeur cible ou pour le maximiser.

Par souci de précision, on dira donc que le système est « verrouillé » lorsque le critère d'optimisation choisi est satisfait. Cela peut correspondre à la situation dans laquelle la fréquence d'émission Fla et la fréquence de résonance F0 se correspondent ou lorsque ces fréquences sont décalées l'une de l'autre d'un écart déterminé.

On note qu'en appliquant un signal de modulation sinusoïdal, on limite l'apparition d'harmoniques dans le signal fourni par le photodétecteur PD (par comparaison avec une modulation en créneau par exemple), les harmoniques détectées par le dispositif de verrouillage R étant alors bien représentatives de la qualité du verrouillage entre la fréquence d'émission et la fréquence de résonance.

On note également que les mêmes principes de verrouillage sont applicables à une configuration dans laquelle le laser présente une fréquence d'émission fixe, et dans laquelle le dispositif d'ajustement est associé au filtre de manière à ajuster sa fréquence de résonance.

La présente description exploite les principes qui viennent d'être présentés pour proposer une source laser d'un rayonnement lumineux multispectral, présentant donc une pluralité de raies spectrales, ces raies spectrales étant séparées d'un intervalle spectral maitrisé. A titre d'exemple, pour des applications dans le domaine de la transmission par multiplexage par répartition en longueur d'onde, on cherche à fournir une source laser d'un rayonnement lumineux multispectral dont les raies spectrales sont précisément séparées (à 5% près) d'un intervalle de 100GHz ou de 50 GHz par exemple.

En référence à la figure 2a, qui présente un premier mode de réalisation de l'invention, une telle source 1 comprend une banque B de lasers accordables La, Lb, Lc. A titre d'exemple, les lasers accordables de la banque B peuvent être des lasers à rétroaction répartie. Comme cela est bien connu en soi, chaque laser comprend un réseau de Bragg distribué le long d'une cavité laser. Chaque laser La,Lb,Lc de la banque B est associé à une source de courant Sa, Sb, Sc, permettant son alimentation et la génération d'un rayonnement lumineux. Comme on l'a déjà noté, la fréquence d'émission d'un laser à rétroaction réparti est dépendant de son courant d'alimentation. En ajustant ce courant, on peut ajuster cette fréquence d'émission ce qui rend ces lasers « accordables » au sens de la présente description. La banque B peut contenir un nombre quelconque de lasers accordables, typiquement entre 10 et 100 lasers. Bien entendu l'invention n'est nullement limitée à une banque de lasers à rétroaction répartie et s'applique à tout laser accordable. Il peut dans un exemple complémentaire s'agir d'un laser du type DBR (pour « Distributed Bragg reflector laser » ou laser à réflecteur de Bragg distribué).

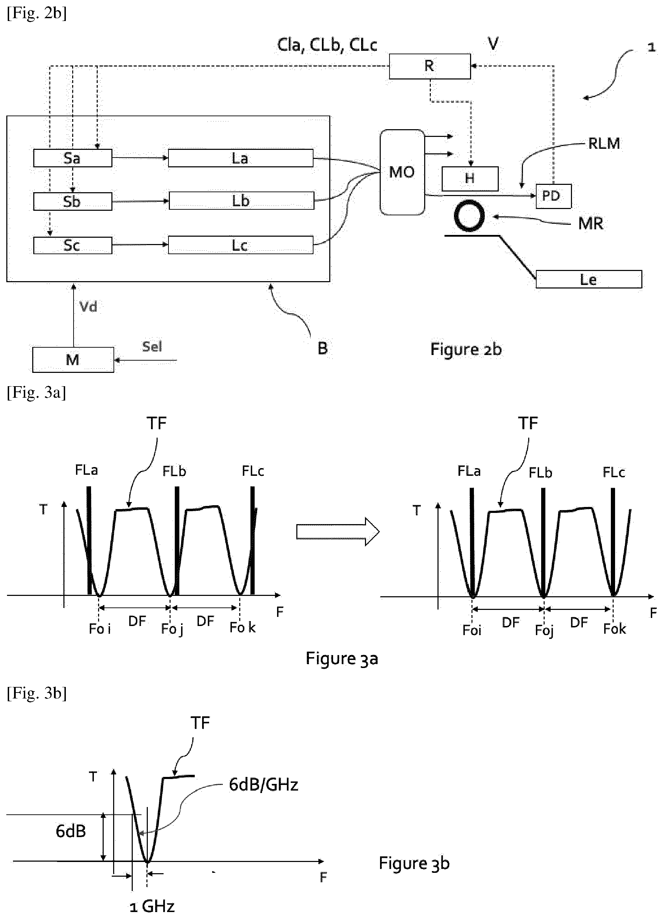

Les lasers de la banque B sont conçus pour émettre des rayonnements lumineux présentant des fréquences d'émission étagées, typiquement écartées d'un intervalle spectral de 100GHz pour les applications WDM, comme cela a été exposé précédemment. Toutefois, et comme cela est rendu apparent sur la partie gauche de la figure 3a (où sont représentées les fréquences Fla,Flb,Flc et la fonction de transfert du filtre FT), la variabilité du procédé de fabrication de la banque B ne permet pas de maitriser parfaitement l'intervalle spectral séparant les fréquences d'émission FLa,FLb,FLC des lasers de la banque B. L'intervalle spectral séparant deux lasers successifs (en les ordonnant par fréquence d'émission) est donc variable, et cette variation en l'absence de tout mécanisme de verrouillage peut être de l'ordre ou supérieure à +/-20%. On note également que la température de fonctionnement de la banque B peut affecter et faire dériver les fréquences d'émission des lasers.

Revenant à la description du mode de réalisation de la figure 2a, les lasers accordables La,Lb,Lc de la banque sont couplés à un mélangeur optique MO par l'intermédiaire de guides d'onde. Ce mélangeur MO produit au moins un rayonnement lumineux multispectral RLM, une raie spectrale de ce rayonnement correspondant à une fréquence d'émission du rayonnement lumineux émis par un laser accordable de la banque B. Le mélangeur MO peut fournir une pluralité de rayonnements lumineux mutlispectraux, identiques entre eux.

Le rayonnement lumineux multispectral RLM (ou une pluralité de tels rayonnements) forme le rayonnement dit « utile » de la source 1, c'est-à-dire le rayonnement qui peut être exploité par d'autres éléments, modulateurs optiques, interrupteurs optiques... lorsque par exemple la source 1 forme un composant d'un système de communication. Une partie au moins d'un rayonnement multispectral « utile » est prélevé pour permettre l'alignement des fréquences d'émission des lasers accordables de la banque B sur un peigne de fréquences présentant un intervalle spectral déterminé.

Cette partie prélevée du rayonnement lumineux multispectral est guidée par l'intermédiaire d'un guide d'onde vers un filtre optique MR présentant une fonction de transfert TF définissant un gabarit du peigne de fréquences présentant l'intervalle spectral DF déterminé, comme cela est rendu visible sur la figure 3a. Dit autrement, deux fréquences de résonance F0i, F0j, F0k successives du filtre MR sont séparées par un intervalle spectral déterminé DF. A titre d'exemple, le filtre optique MR peut être un résonateur, par exemple un micro résonateur en anneau ou de type Fabry Perrot, qui permet de maitriser avec précision, par exemple à 5% près, l'intervalle spectral DF présent entre deux fréquences de résonance F0i,F0j,F0k. Quelle que soit sa nature, le filtre optique MR est disposé en aval de la banque B de lasers accordables, et plus précisément en aval du mélangeur optique MO, pour ainsi recevoir le rayonnement lumineux multispectral RLM. Afin de pouvoir discriminer avec suffisamment de sensibilité un écart en fréquence imparti par la modulation, la fonction de transfert du filtre MR doit être particulièrement étroite, présentant préférentiellement une pente supérieure 6dB/GhZ, lorsque l'on s'écarte d'un gigahertz ou plus d'une de ses fréquences de résonance. Une telle caractéristique est représentée sur la figure 3b.

Le filtre optique MR peut comprendre un dispositif d'ajustement de la pluralité de ses fréquences de résonance F0i, F0j, F0k. Ainsi, lorsque le filtre MR est mis en œuvre par un résonateur en anneau, ce dispositif peut être un réchauffeur H permettant de décaler en fréquence le peigne de fréquences propres, comme cela sera exposé en détail dans une section ultérieure de la présente description.

La source 1 représentée sur la figure 2a comprend également un photodétecteur PD disposé en aval du filtre optique MR pour établir un signal V représentatif du rayonnement lumineux multispectral MLR.

Elle comprend également un modulateur M associé à la banque de lasers accordables B, le modulateur M étant commandable par l'intermédiaire d'un signal de sélection Sel. Le modulateur M a pour fonction de fournir un signal Vd modulant la fréquence d'émission du rayonnement lumineux émis par un laser accordable avec un signal de modulation de fréquence Fd. Le signal de modulation Vd, dont la forme générale est du type cos (2.Pi*Fd*t), présente un fréquence de modulation Fd relativement faible, de l'ordre de quelques kHz à quelques MHz, typiquement de l'ordre de 5kHz, de quelques 10kHz, voire 1MHz ou plus. L'amplitude du signal de modulation Vd est choisie de sorte que l'excursion en fréquence de la fréquence d'émission du rayonnement lumineux émis par un laser accordable soit de l'ordre de 1GHz ou plus. Le signal de sélection Sel de ce mode de réalisation permet de choisir le laser accordable de la banque B sur lequel sera appliquée la fréquence de modulation Fd.

Pratiquement, cette modulation de la fréquence peut être appliquée en modulant avec le signal de modulation Vd, le courant produit par la source de courant Sa,Sb,Sc associée au laser accordable La,Lb,Lc sélectionné. D'autres moyens de modulation de la fréquence d'émission du laser peuvent être exploités. Il peut ainsi s'agir d'appliquer le signal de modulation Vd sur un réchauffeur associé au laser, ou sur un dispositif injection/déplétion de porteurs libres dans le laser. D'une manière générale donc, le modulateur M est électriquement relié à la banque de laser, de manière à appliquer le signal de modulation à un moyen d'ajustement de la fréquence d'émission dont est muni le laser accordable sélectionné.

Enfin, la source laser 1 représentée sur la figure 2a comprend un dispositif de verrouillage R d'un laser accordable de la banque B. Ce dispositif de verrouillage R est relié à la banque de laser B par l'intermédiaire de commandes CLa,CLb,CLc respectivement reliées aux sources de courant Sa,Sb,Sc. Il est également relié au photodétecteur PD pour recevoir le signal V établi par cet élément et au dispositif d'ajustement H du filtre MR pour le commander. Le dispositif de verrouillage R est configuré pour commander le modulateur M et sélectionner, à l'aide du signal de sélection Sel, le laser accordable auquel est appliqué le signal de modulation Vd. Le dispositif de verrouillage R est également configuré pour, au cours d'une phase de verrouillage, mettre en œuvre une boucle de régulation visant à accorder la fréquence d'émission du laser accordable sélectionné Fla,Flb,Flc et la verrouiller sur une fréquence de résonance du filtre Foi,Foj,Fok. Cette boucle de régulation met en œuvre les principes exposés en relation avec la description des figures 1a à 1c. Elle peut notamment effectuer une transformée de Fourrier (ou toute autre transformation dans le domaine fréquentiel) du signal V produit par le photodétecteur PD et déterminer la part de puissance présente dans la fréquence de modulation Fd et dans ses harmoniques, notamment dans la deuxième harmonique. Elle peut également déterminer la phase de ces signaux. Le dispositif de verrouillage R peut, sur cette base, élaborer la commande associée au laser accordable sélectionné permettant d'ajuster sa fréquence d'émission pour la verrouiller sur une fréquence de résonance du filtre MR.

Dans le mode de réalisation représenté sur la figure 2a, les sources de courant Sa,Sb,Sc sont réglables, et l'ajustement de la fréquence d'émission d'un laser est réalisé en contrôlant en rétroaction son courant moyen d'alimentation fourni par la source de courant réglable associée. Comme on l'a déjà énoncé, ce courant moyen, c'est-à-dire la partie continue du courant d'alimentation du laser, affecte la fréquence d'émission de ce laser.

La source laser 1 du mode de réalisation représenté sur la figure 2a est mise en œuvre, au cours d'une phase de verrouillage, en sélectionnant successivement un laser accordable à verrouiller parmi les lasers accordables de la banque B. Ainsi, le dispositif de verrouillage R peut comprendre une machine d'état émettant un signal de sélection Sel sélectionnant circulairement un des lasers accordables de la banque B, par exemple au cours de périodes de verrouillage successives dont la durée peut être typiquement comprise entre quelques microsecondes à quelques millisecondes. Au cours de chaque période de verrouillage, le dispositif de verrouillage R met en œuvre les traitements conduisant à verrouiller la fréquence d'émission du laser accordable sélectionné sur la fréquence propre F0 la plus proche du filtre optique MR. A l'issue d'un cycle complet, chaque laser accordable est bien verrouillé sur une fréquence propre du filtre optique. Dans cet état verrouillé de la banque B, représenté sur la partie droite de la figure 3a, le rayonnement lumineux multispectral RLM se conforme bien au gabarit spectral imposé par le filtre optique MR : il présente une pluralité de raies spectrales FLa,FLb,FLc séparées entre elles d'un intervalle spectral déterminé DF par le filtre optique. L'intervalle spectral DF séparant deux fréquences propres F0 adjacentes du filtre étant maitrisé, typiquement à 5% près ou mieux, cette propriété peut être conférée aux fréquences d'émissions des lasers accordables de la banque B.

En répétant les cycles de régulation les uns à la suite des autres, en multiplexage temporel, on peut maintenir dans le temps l'état verrouillé de la banque de lasers accordables sur le filtre, et compenser des éventuelles dérives, notamment celles liées aux variations de température des lasers.

Optionnellement, le dispositif de verrouillage R peut mettre en œuvre une autre boucle de régulation pour étalonner le peigne de fréquences de résonance du filtre optique MR et l'aligner sur des fréquences de résonance cibles, en valeur absolue. A cet effet, et comme cela est représenté sur la figure 2b, on fournit un rayonnement lumineux issu d'un laser étalon Le sur un port complémentaire du filtre MR. Ce laser étalon présente une fréquence d'émission modulée, tout comme les autres lasers accordables La,Lb,Lc de la banque B. Toutefois, le laser accordable étalon Le n'est pas relié au dispositif de verrouillage R et sa fréquence d'émission, naturellement stable n'est pas ajustée par ce dispositif.

Le dispositif de verrouillage R peut extraire de la transformée de Fourrier du signal V produit par le photodétecteur PD, les composantes fréquentielles correspondant à la fréquence de modulation du laser accordable étalon et le dispositif de verrouillage R peut commander le réchauffeur H, ou tout autre dispositif d'ajustement de la pluralité des fréquences de résonance F0i,F0j,F0k du filtre, afin de décaler en fréquence ce peigne de fréquences propres et le recaler sur la fréquence cible fournie par le laser étalon. Ce fonctionnement est illustré sur la figure 3c. Cette boucle de régulation d'étalonnage du filtre MR et la boucle de régulation de verrouillage des lasers accordables ne sont pas forcément distinctes l'une de l'autre, et selon une approche possible, le dispositif de verrouillage R met en œuvre une unique boucle de régulation ou des traitements visant à simultanément optimiser la source laser 1 et le filtre MR afin de produire un rayonnement lumineux multispectral RLM présentant une pluralité de raies spectrales déterminées, c'est-à-dire dont chaque raie est précisément positionnée dans le domaine fréquentiel.

On note que l'étalonnage du peigne de fréquences de résonance du filtre optique MR qui vient d'être présenté est parfaitement optionnel, et que le principal objet de l'invention est de maitriser l'intervalle spectral présent entre les raies spectrales du rayonnement multispectral produit par la source laser 1. Il est notamment tout à fait acceptable que les valeurs absolues des fréquences d'émission de chaque laser accordable de la source dérivent, notamment sous l'effet de la température de fonctionnement de cette source, dans la mesure où les intervalles spectraux présents entre deux raies spectrales adjacentes du rayonnement multispectral restent maitrisés.

La figure 4 représente un autre mode de réalisation de la source laser 1. Dans ce mode de réalisation, chaque laser accordable La, Lb, Lc de la banque B est muni d'un réchauffeur Ha, Hb, Hc. Comme cela est bien connu en soi, le réchauffeur associé à un laser permet de maitriser finement la fréquence d'émission du laser en faisant varier sa température. Dans la configuration de la source laser 1 de ce mode de réalisation, les commandes CLa' , CLb' , CLc' élaborées par le dispositif de verrouillage R sont respectivement reliées aux réchauffeurs Ha,Hb,Hc en vue de les commander. Dans ce mode de réalisation donc, l'ajustement de la fréquence d'émission des lasers accordables de la banque B est réalisé par l'intermédiaire des réchauffeurs Ha,Hb,Hc, en contrôlant la température du laser accordable sélectionné, et non par contrôle de son courant moyen d'alimentation comme cela était le cas dans le premier mode de mise en œuvre. Tous les autres éléments de la source laser 1 du deuxième mode de réalisation sont identiques à ceux du premier mode et, par souci de concision, leur description ne sera pas répétée. On peut bien entendu envisager de combiner ces deux modes de réalisation, et de réaliser l'ajustement de la fréquence d'émission des lasers accordables de la banque B, en contrôlant à la fois le courant moyen d'alimentation de la source de courant associé à un laser accordable sélectionné et, simultanément, en contrôlant la température de ce laser à l'aide d'un réchauffeur associé.

Dans une autre variante des modes de réalisation de la source laser 1 représentée sur les figures 2a et 4, chaque laser La,Lb,Lc de la banque B comprend cette fois un dispositif d'injection/déplétion de porteurs, par exemple un guide d'onde disposé sous le laser La,Lb,Lc. On peut de la même manière maitriser finement la fréquence d'émission du laser en faisant varier la concentration en porteurs libres dans le dispositif disposé sous le laser. Dans la configuration de la source laser 1 de ce mode de réalisation, les commandes CLa' , CLb' , CLc' élaborées par le dispositif de verrouillage R sont respectivement reliées aux dispositifs d'injection/déplétion de porteurs.

Comme on l'a déjà énoncé, chaque laser accordable de la banque B de lasers peut être muni d'une pluralité de moyens d'ajustement de sa fréquence d'émission. Dans ce cas, il n'est pas nécessaire que le même moyen soit exploité pour moduler la fréquence d'émission de ce laser et pour l'ajuster à une fréquence de résonance du filtre MR. Un premier moyen peut ainsi être exploité pour moduler cette fréquence d'émission (par exemple en appliquant le signal de modulation Vd sur la source de courant d'alimentation du laser sélectionné et ainsi moduler ce courant d'alimentation) et un second moyen, différent du premier, peut être exploité pour ajuster la fréquence d'émission de ce laser à une fréquence de résonance du filtre (par exemple en maitrisant la température produite par un réchauffeur associé au laser).

Dans le mode de réalisation de la figure 5, en multiplexage fréquentiel, le modulateur M génère une pluralité de signaux de modulation Vda,Vdb,Vdc, chaque signal de modulation étant associé à un laser accordable La,Lb,Lc de la banque B. Chaque signal de modulation présente une fréquence de modulation Fda,Fdb,Fdc distincte des fréquences des autres signaux de modulation. Ces signaux sont appliqués simultanément au cours d'une phase de verrouillage, et avantageusement de manière permanente, sur les lasers auxquels ils sont respectivement associés, ici sur les sources de courant de ces lasers. Le modulateur M permet ainsi de moduler les fréquences d'émission des lasers accordables par l'intermédiaire d'une fréquence de modulation propre à chaque laser accordable. A titre d'exemple, les fréquences de modulation peuvent être comprises dans la gamme 1kHz à 30 kHz. Dans le cas de ce mode de réalisation, il n'est donc pas nécessaire que le modulateur M soit commandable par l'intermédiaire d'un signal de sélection. Le reste de la source laser 1 de ce mode de réalisation est identique au premier mode de réalisation de la figure 2a, et sa description sera donc omis ici par souci de concision. On peut notamment prévoir, comme dans le premier mode de réalisation, d'injecter un rayonnement fourni par un laser étalon dans un port complémentaire du filtre MR, et exploiter un réchauffeur H associé à ce filtre MR, pour précisément positionner dans le domaine fréquentiel chaque raie du rayonnement lumineux multispectral RLM.

Les traitements mis à en œuvre par le dispositif de verrouillage R sont naturellement adaptés à ce mode de réalisation, mais reposent sur les mêmes principes exposés dans les figures 1a à 1c. En particulier, l'analyse dans le domaine fréquentiel du signal V fourni par le photodétecteur fait apparaître, comme cela est visible sur la figure 6, chacune des fréquences de modulation et leurs harmoniques. Ces fréquences de modulation étant connues, le dispositif de verrouillage peut être configuré pour les identifier et mettre en œuvre les traitements visant à ajuster la fréquence d'émission du laser accordable associé.

Sur la représentation de la figure 5, les signaux de commande CLa,CLb,CLc préparés par le dispositif de verrouillage R sont respectivement reliés aux sources de courant Sa,Sb,Sc de la banque de lasers accordables. Toutefois, tout comme dans le mode de réalisation de la figure 4, il est envisageable dans le cadre du mode de réalisation de la figure 5, de contrôler la fréquence d'émission des lasers accordables à l'aide de réchauffeurs respectivement associés à ces lasers accordables ou à tout autre moyen d'ajustement de la fréquence d'émission de ces lasers.

La figure 7 représente une variante applicable aux deux modes de réalisation qui viennent d'être présentés. Dans cette variante, un unique élément optique (désigné MO+MR sur la figure) met en œuvre les fonctions du mélangeur MO et du filtre MR. Il peut s'agir par exemple d'un multiplexeur mis en œuvre par un réseau de guides d'onde (« Arrayed waveguide grating » selon la terminologie anglo-saxonne) ou mis en œuvre par un réseau en échelle. Cet élément présente une fonction de transfert identique à celle présentée sur la figure 3a.

De manière très avantageuse, le dispositif de verrouillage R d'une source laser 1 conforme à l'invention exploite également le dispositif d'ajustement H de la pluralité de fréquences de résonance du filtre optique MR,MO+MR afin de verrouiller les fréquences d'émission des rayonnements lumineux des lasers accordables. Cette approche peut être déployée pour tous les modes de mise en œuvre qui viennent d'être présentés et ne nécessite nullement l'emploi d'un laser étalon. Elle vise à maitriser les intervalles spectraux présents entre deux raies spectrales adjacentes du rayonnement multispectral, sans toutefois imposer la position exacte de ces raies spectrale, en valeur absolue. On peut de la sorte laisser « flotter » le positionnement spectral du rayonnement multispectral, tout en maitrisant les intervalles spectraux présents entre deux raies spectrales adjacentes. On évite ainsi de solliciter de manière excessive les moyens d'ajustement de la fréquence d'émission des lasers accordables, en cherchant à forcer ces fréquences sur une fréquence absolue, ce qui pourrait conduire à affecter et faire varier de manière excessive la puissance émise par le laser (lorsque par exemple les moyens d'ajustement sont constitués par les sources de courant des lasers) ou ce qui pourrait conduire à une consommation énergétique excessive de la source (lorsque par exemple les moyens d'ajustement sont constitués par des réchauffeurs). On note que dans certains cas, l'ajustement de la fréquence d'émission d'un laser, lorsque l'on chercher à imposer une fréquence absolue d'émission, peut conduire à chercher à refroidir cette source, ce qui n'est pas toujours possible aisément.

Le dispositif de verrouillage R est configuré pour, au cours d'une phase de régulation qui peut précéder la phase de verrouillage, activer le dispositif d'ajustement H de la pluralité de fréquences de résonance du filtre optique MR, afin de positionner ces fréquences de résonance relativement aux fréquences d'émission des laser dans une configuration dite « moyenne », qui tend à rapprocher l'un de l'autre les deux peignes de fréquences. Cette configuration moyenne est par exemple celle qui permettra de solliciter de manière peu intensive les moyens d'ajustement de la fréquence d'émission des lasers accordables pour verrouiller le système, au cours de la phase de verrouillage.

De nombreux critères d'optimisation peuvent être déployés par le dispositif de verrouillage R au cours de la phase de régulation pour établir cette configuration moyenne. Il peut par exemple s'agir d'optimiser la somme des écarts respectivement présents entre les fréquences d'émission des lasers accordables et les fréquences de résonance du filtre. Il peut s'agir d'une somme quadratique ou d'optimiser le maximum de ces écarts, en valeur absolue ou relative.

Tout comme dans la phase de verrouillage, le dispositif de verrouillage R détermine à partir du signal V établi par le photodétecteur, les puissances présentes la seconde harmonique et/ou dans le fondamental du signal de modulation ainsi que l'information de phase du signal de modulation. Ces données peuvent être exploitées, par exemple à l'aide du graphe de la figure 1e, pour déterminer l'écart présent entre la fréquence d'émission d'un laser et la fréquence de résonance correspondante du filtre.

Le dispositif de verrouillage R peut fonctionner en multiplexage temporel ou fréquentiel au cours de cette phase de régulation.

A titre d'exemple, il peut être judicieux de positionner, au cours de cette phase de régulation, les fréquences de résonance des filtres pour que ces fréquences soit respectivement supérieure, avec un écart faible, aux fréquences d'émission des lasers accordables. Il est alors possible, au cours de la phase de verrouillage, d'ajuster à la hausse ces fréquences d'émission à l'aide de réchauffeurs opérés au juste nécessaire.

Quel que soit le critère d'optimisation retenu, le dispositif de régulation R peut être configuré pour, pendant cette phase de régulation, commander le dispositif d'ajustement H du filtre optique MR et par exemple balayer son domaine de fonctionnement. Au cours de cette excursion, par multiplexage temporel ou fréquentiel des mesures, le dispositif de régulation R repère les écarts existants respectivement entre les fréquences de résonance du filtre MR et les fréquences d'émission des lasers accordables de la banque. A l'issue de cette excursion, le dispositif de régulation identifie la commande du dispositif d'ajustement H du filtre optique MR qui répond au mieux au critère d'optimisation choisi, et applique cette commande au dispositif d'ajustement H afin de placer le filtre dans la configuration moyenne. Mais la phase de régulation peut être opérée selon d'autres approches que celle, systématique, visant à explorer le domaine de fonctionnement du dispositif d'ajustement H. Il peut par exemple s'agir d'appliquer une méthode d'optimisation continue, par exemple sur la base du gradient du critère d'optimisation, au cours de laquelle on fait varier pas à pas la commande du dispositif d'ajustement H du filtre optique MR afin de rechercher un optimum du critère d'optimisation. Dans tous les cas, et quel que soit l'approche retenue, la phase de régulation mise en œuvre par le dispositif de régulation R conduit à produire et à appliquer une commande au dispositif d'ajustement H, visant à placer le filtre MR optique dans une configuration moyenne.

La phase de régulation peut précéder la phase de verrouillage. On peut répéter, à des moments choisis, cette phase de verrouillage pour prendre en compte des éventuelles variations du point de fonctionnement du système. On peut également envisager de mener les phases de verrouillage et de régulation de manière concourante, par exemple dans une boucle de régulation unique, notamment lorsque la phase de régulation met en œuvre une technique d'optimisation continue du type gradient. On ajuste alors simultanément les fréquences d'émission des lasers et, collectivement, les fréquences de résonance du filtre, dans le but de mettre en correspondance, au juste nécessaire, ces fréquences.

Quel que soit le mode de réalisation choisi, une source laser 1 conforme à l'invention peut être mise en œuvre par des technologies photoniques à base de silicium. Selon ces technologies, les guides d'onde et autres composants passifs sont réalisés sur un substrat de silicium (et avantageusement sur un substrat de silicium sur isolant) et les autres éléments (sources laser, photodétecteurs, mélangeur optique, réchauffeurs) peuvent être formés, par dépôt ou par report, sur ce substrat. On peut notamment former sur une même puce photonique, c'est à dire sur/dans un même substrat, la banque de lasers accordables B, le filtre optique MR muni de son dispositif d'ajustement, le photodétecteur, ainsi que les guides d'onde reliant ces éléments.

Cette puce photonique peut être associée à une puce électronique comprenant certains des autres composants électroniques de la source laser 1, tel que les sources de courant voire même le dispositif de verrouillage. Dans certains cas, une unique puce peut comprendre les éléments photoniques et électroniques de la source 1. Le dispositif de verrouillage, s'il n'est pas intégré dans une des puces, peut être mis en œuvre par un dispositif de calcul (un microcontrôleur, un calculateur de traitement de signal DSP ou un ASIC) disposé sur un support et auquel sont électriquement reliées la ou les puces.

On note que la banque de lasers accordables B et le filtre optique MR étant intégrés à une même puce, sur/dans un même substrat, ils sont soumis aux mêmes évolutions de température. Cette température de fonctionnement affecte la fréquence **d'émission** des lasers accordable tout comme la fréquence de résonance du filtre MR, notamment lorsqu'il est formé d'un résonnateur en anneau. Avantageusement, on configurera ces éléments pour que la dérive en température des fréquences d'émission/de résonance soit identique ou en tout cas très similaire. Ainsi, le coefficient de dérive en température (en nm/°C) des fréquences **d'émission** des laser accordables et le coefficient de dérive en température des fréquences de résonance peuvent être identiques, à 10% près.

On note qu'une source laser 1 conforme à l'invention est particulièrement intéressante, car il est possible d'accorder la fréquence **d'émission** des lasers accordables de la banque B à l'aide d'un circuit particulièrement simple. C'est notamment le cas de la partie photonique de la source, augmentée d'un unique photodétecteur PD et d'un unique filtre MR, par exemple un micro résonateur en anneau. On limite de la sorte le nombre de plots additionnel d'interconnexion dont la puce photonique doit être munie pour permettre la fonctionnalité de verrouillage des lasers accordables.

Le rayonnement lumineux multispectral modulé, qui forme le rayonnement « utile » fourni par la source, peut également être exploité pour la calibration et/ou le verrouillage des composants photoniques (interrupteurs, modulateurs...) disposés en aval de la source laser 1, lorsque cette source 1 est exploitée dans un système plus complexe. Un exemple d'une telle utilisation d'une source laser conforme à l'invention est représenté sur la figure 8. Sur cette figure, une source laser 1 présente au moins un port de sortie (deux ports P1, P2 sur la figure 8) produisant chacun un rayonnement lumineux multispectral RLM1, RLM2. Ce rayonnement est donc composé spectralement d'une pluralité de raies séparées d'un intervalle spectral déterminé. Une au moins de ces raies est modulée en fréquence, comme cela a été exposé en détail en relation avec l'exposé de chacun des modes de réalisation de la source 1 (en multiplexage temporel ou fréquentiel). Le rayonnement lumineux RLM1, RLM2 produit par un port P1, P2 de la source 1 se propage dans un guide d'onde couplé à ce port P1, P2.

Le guide d'onde est lui-même couplé à un composant photonique comprenant un filtre présentant une fréquence de résonance accordable, ici deux modulateurs MRA1,MRA2 mettant en œuvre chacun un réseau de micro résonateurs. Comme cela est bien connu en soi dans le domaine des télécommunications, ce modulateur MRA1, MRA2 permet de conditionner chaque raie spectrale du rayonnement lumineux multispectral (ici à l'aide de micro résonateurs respectivement accordés à ces raies) pour transmettre de manière multiplexée en fréquence des signaux d'information S1,S2,S3. Pour permettre le bon fonctionnement du système présenté sur la figure 8, il peut être avantageux d'accorder précisément les fréquences de résonance des résonateurs constituant les modulateurs MRA1, MRA2, aux fréquences d'émission des lasers accordables de la source 1, c'est-à-dire les raies spectrales composant le rayonnement lumineux multispectral RLM1, RLM2.

Pour permettre cet ajustement, les résonateurs du réseau MRA1, MRA2 sont associés à des réchauffeurs H11,H12,H13 permettant d'ajuster leur fréquence de résonance aux raies spectrales auxquelles ils sont associés, et donc d'accorder le composant optique. Et on a également prévu un photodétecteur de surveillance P1, P2 couplé au guide d'onde afin d'établir un signal électrique représentatif du rayonnement multispectral.

Un régulateur R' recueille le signal V1, V2 fourni par le photodétecteur de surveillance P1, P2 et produit les signaux de commande Cd11,Cd12,Cd13 ; Cd21,Cd22,Cd23 permettant de contrôler les réchauffeurs H11,H12,H13 ; H21n,H22,H23 des modulateurs MRA1,MRA2, et donc d'ajuster les fréquences de résonance des micro résonateurs. Le régulateur exploite les mêmes principes que ceux présentés en figures 1a à 1e et 3c pour déterminer ces signaux de commande.

Bien entendu l'invention n'est pas limitée aux modes de mise en œuvre décrits et on peut y apporter des variantes de réalisation sans sortir du cadre de l'invention tel que défini par les revendications.

## Revendications

1. Source laser (1) pour émettre au moins un rayonnement lumineux multispectral (RLM) présentant une pluralité de raies spectrales séparées d'un intervalle spectral déterminé, la source laser (1) comprenant :
- une banque de lasers accordables (B), une raie spectrale du rayonnement lumineux multispectral (RLM) correspondant à une fréquence, appelée « fréquence d'émission », du rayonnement lumineux émis par un laser accordable (La,Lb,Lc) de la banque (B) ;
- des moyens d'ajustement des fréquences d'émission des lasers accordables ;
- un filtre optique (MR;MO+MR) présentant une pluralité de fréquences de résonance, deux fréquences de résonance successives étant séparées de l'intervalle spectral déterminé, le filtre optique (MR;MO+MR) étant disposé optiquement en aval de la banque de lasers accordables (B), le filtre optique (MR;MO+MR) étant muni d'un dispositif d'ajustement (H) de la pluralité de fréquences de résonance ;
- un photodétecteur (PD) disposé optiquement en aval du filtre optique (MR) pour établir un signal représentatif (V) du rayonnement lumineux multispectral transmis à travers le filtre (MR;MO+MR);
- un modulateur (M) associé aux moyens d'ajustement des fréquences d'émission des lasers accordables, le modulateur (M) étant configuré pour générer un signal de modulation (Vd;Vda,Vdb,Vdc) et moduler la fréquence d'émission du rayonnement lumineux émis par au moins un laser accordable (La,Lb,Lc) de la banque (B);
- un dispositif de verrouillage (R) relié aux moyens d'ajustement de la fréquence d'émission des lasers accordables et relié au dispositif d'ajustement (H) de la pluralité de fréquences de résonance, le dispositif de verrouillage (R) étant configuré pour traiter le signal représentatif du rayonnement multispectral (V) et verrouiller les fréquences d'émission des laser accordables aux fréquences de résonance du filtre (MR;MO+MR) .

2. Source laser (1) selon la revendication précédente comprenant un mélangeur optique (MO) associé à la banque de lasers accordables (B) pour combiner les rayonnements lumineux émis par les lasers accordables de la banque et fournir le rayonnement lumineux multispectral (RLM) au filtre (MR).

3. Source laser (1) selon l'une des revendications précédentes dans laquelle le filtre optique (MR) est un micro résonateur en anneau.

4. Source laser (1) selon l'une des revendications précédentes dans laquelle le dispositif d'ajustement (H) de la pluralité de fréquences de résonance est un réchauffeur.

5. Source laser (1) selon l'une des revendications précédentes dans laquelle les moyens d'ajustement de la fréquence d'émission des lasers accordables sont choisis dans la liste formée de : une source de courant, un réchauffeur, dispositif d'injection/déplétion des porteurs libres.

6. Source laser (1) selon l'une des revendications précédentes dans laquelle les lasers (La,Lb,Lc) de la banque de lasers accordables (B) sont des lasers à rétroaction répartie ou des lasers à réflecteur de Bragg distribué.

7. Source laser (1) selon l'une des revendications précédentes dans laquelle le dispositif de verrouillage (R) est configuré pour commander le modulateur (M) et sélectionner, à l'aide d'un signal de sélection (Sel), le laser accordable (La,Lb,Lc) auquel est appliqué le signal de modulation (Vd).

8. Source laser (1) selon l'une des revendications 1 à 6 dans laquelle le modulateur (M) génère une pluralité de signaux de modulation (Vda,Vdb,Vdc) distincts les uns des autres, les signaux de modulation (Vda,Vdb,Vdc) étant appliqués aux lasers accordables (La,Lb,Lc).

9. Source laser (1) selon l'une des revendications précédentes dans laquelle le modulateur (M) est configuré pour produire un signal de modulation (Vd;Vda,Vdb,Vdc) sinusoïdal présentant une fréquence de modulation (Fd;Fda,Fdb,Fdc).

10. Source laser (1) selon la revendication précédente dans laquelle le dispositif de verrouillage (R) est configuré pour établir une mesure représentative de la puissance présente dans une deuxième harmonique et/ou dans une composante principale et/ou une mesure représentative de la phase de la composante principale de la fréquence de modulation (Fd;Fda,Fdb,Fdc) du signal représentatif du rayonnement multispectral (V).

11. Source laser (1) selon l'une des revendications précédentes dans laquelle la banque de lasers accordables (B) et le filtre optique (MR) sont intégrés sur/dans un même substrat d'une puce photonique.

12. Source laser (1) selon la revendication précédente dans laquelle dans laquelle le coefficient de dérive en température des fréquences d'émission des lasers accordables et le coefficient de dérive en température des fréquences de résonance sont identiques, à 10% près.

13. Procédé d'utilisation d'une source laser (1) selon l'une des revendications précédentes, le procédé étant mise en œuvre par le dispositif de verrouillage (R) et comprenant :
- une phase de régulation pour activer le dispositif d'ajustement (H) de la pluralité de fréquences de résonance du filtre optique (MR) ;
- une phase de verrouillage pour verrouiller la fréquence d'émission du rayonnement lumineux du laser accordable sélectionné à une fréquence de résonance du filtre.

14. Procédé d'utilisation selon la revendication précédente dans lequel la phase de verrouillage est opérée après la phase de régulation.

## Patentansprüche

1. Laserquelle (1) zum Emittieren mindestens einer multispektralen Lichtstrahlung (RLM), aufweisend eine Vielzahl von Spektrallinien, die durch ein bestimmtes Spektralintervall getrennt sind, die Laserquelle (1) umfassend:
- eine Bank (B) abstimmbarer Laser, wobei eine Spektrallinie der multispektralen Lichtstrahlung (RLM) einer als "Emissionsfrequenz" bezeichneten Frequenz der Lichtstrahlung, die durch einen abstimmbaren Laser (La,Lb,Lc) der Bank (B) emittiert wird, entspricht;
- Mittel zum Einstellen der Emissionsfrequenzen der abstimmbaren Laser;
- ein optisches Filter (MR;MO+MR), aufweisend eine Vielzahl von Resonanzfrequenzen, wobei zwei aufeinanderfolgende Resonanzfrequenzen durch das bestimmte Spektralintervall getrennt sind, wobei das optische Filter (MR;MO+MR) hinter der Bank (B) abstimmbarer Laser optisch angeordnet ist, wobei das optische Filter (MR;MO+MR) mit einer Vorrichtung (H) zum Einstellen der Vielzahl von Resonanzfrequenzen versehen ist;
- einen Photodetektor (PD), der hinter dem optischen Filter (MR) optisch angeordnet ist, um ein Signal (V), das für die multispektrale Lichtstrahlung repräsentativ ist, die durch das Filter (MR;MO+MR) durchgeht, zu erzeugen;
- einen Modulator (M), der den Mitteln zum Einstellen der Emissionsfrequenzen der abstimmbaren Laser zugeordnet ist, wobei der Modulator (M) konfiguriert ist, um ein Modulationssignal (Vd;Vda,Vdb,Vdc) zu erzeugen und die Emissionsfrequenz der Lichtstrahlung, die durch mindestens einen abstimmbaren Laser (La,Lb,Lc) der Bank (B) emittiert wird, zu modulieren;
- eine Festlegungsvorrichtung (R), die mit den Mitteln zum Einstellen der Emissionsfrequenz der abstimmbaren Laser verbunden ist und mit der Vorrichtung (H) zum Einstellen der Vielzahl von Resonanzfrequenzen verbunden ist, wobei die Festlegungsvorrichtung (R) konfiguriert ist, um das Signal, das für die multispektrale Strahlung (V) repräsentativ ist, zu verarbeiten und die Emissionsfrequenzen der abstimmbaren Laser auf die Resonanzfrequenzen des Filters (MR;MO+MR) festzulegen.

2. Laserquelle (1) nach dem vorstehenden Anspruch, umfassend einen optischen Mischer (MO), der der Bank (B) abstimmbarer Laser zugeordnet ist, um die Lichtstrahlung, die durch die abstimmbaren Laser der Bank emittiert wird, zu kombinieren und dem Filter (MR) die multispektrale Lichtstrahlung (RLM) bereitzustellen.

3. Laserquelle (1) nach einem der vorstehenden Ansprüche, wobei das optische Filter (MR) ein Ring-Mikroresonator ist.

4. Laserquelle (1) nach einem der vorstehenden Ansprüche, wobei die Vorrichtung (H) zum Einstellen der Vielzahl von Resonanzfrequenzen eine Vorwärmeinrichtung ist.

5. Laserquelle (1) nach einem der vorstehenden Ansprüche, wobei die Mittel zum Einstellen der Emissionsfrequenz der abstimmbaren Laser aus der Liste ausgewählt sind, die ausgebildet ist aus: einer Stromquelle, einer Vorwärmeinrichtung, einer Vorrichtung zum Einspritzen/Entleeren freier Träger.

6. Laserquelle (1) nach einem der vorstehenden Ansprüche, wobei die Laser (La,Lb,Lc) der Bank (B) abstimmbarer Laser Laser mit verteilter Rückkopplung oder Laser mit verteiltem Bragg-Reflektor sind.

7. Laserquelle (1) nach einem der vorstehenden Ansprüche, wobei die Festlegungsvorrichtung (R) konfiguriert ist, um den Modulator (M) zu steuern und mittels eines Auswahlsignals (Sel) den abstimmbaren Laser (La,Lb,Lc), auf den das Modulationssignal (Vd) angewendet wird, auszuwählen.

8. Laserquelle (1) nach einem der Ansprüche 1 bis 6, wobei der Modulator (M) eine Vielzahl von Modulationssignalen (Vda,Vdb,Vdc) erzeugt, die voneinander verschieden sind, wobei die Modulationssignale (Vda,Vdb,Vdc) auf die abstimmbaren Laser (La,Lb,Lc) angewendet werden.

9. Laserquelle (1) nach einem der vorstehenden Ansprüche, wobei der Modulator (M) konfiguriert ist, um ein sinusförmiges Modulationssignal (Vd;Vda,Vdb,Vdc), aufweisend eine Modulationsfrequenz (Fd;Fda,Fdb,Fdc), zu schaffen.

10. Laserquelle (1) nach dem vorstehenden Anspruch, wobei die Festlegungsvorrichtung (R) konfiguriert ist, um eine Messung, die für die Leistung repräsentativ ist, die in einer zweiten Harmonischen und/oder in einer Hauptkomponente vorhanden ist, und/oder eine Messung zu ermitteln, die für die Phase der Hauptkomponente der Modulationsfrequenz (Fd;Fda,Fdb,Fdc) des Signals repräsentativ ist, das für die multispektrale Strahlung (V) repräsentativ ist.

11. Laserquelle (1) nach einem der vorstehenden Ansprüche, wobei die Bank (B) abstimmbarer Laser und das optische Filter (MR) auf/in einem gleichen Substrat eines photonischen Chips integriert sind.

12. Laserquelle (1) nach dem vorstehenden Anspruch, wobei der Temperaturdriftkoeffizient der Emissionsfrequenzen der abstimmbaren Laser und der Temperaturdriftkoeffizient der Resonanzfrequenzen bis auf 10 % identisch sind.

13. Verfahren zum Verwenden einer Laserquelle (1) nach einem der vorstehenden Ansprüche, wobei das Verfahren durch die Festlegungsvorrichtung (R) ausgeführt wird und umfasst:
- eine Regelungsphase zum Aktivieren der Vorrichtung (H) zum Einstellen der Vielzahl von Resonanzfrequenzen des optischen Filters (MR);
- eine Festlegungsphase zum Festlegen der Emissionsfrequenz der Lichtstrahlung des ausgewählten abstimmbaren Lasers auf eine Resonanzfrequenz des Filters.

14. Verwendungsverfahren nach dem vorstehenden Anspruch, wobei die Festlegungsphase nach der Regelungsphase durchgeführt wird.

## Claims

1. Laser source (1) for emitting at least one multispectral light radiation (RLM) having a plurality of spectral lines separated by a determined spectral interval, the laser source (1) comprising:
- a bank (B) of tunable lasers, a spectral line of the multispectral light radiation (RLM) corresponding to a frequency, referred to as the "emission frequency", of the light radiation emitted by a tunable laser (La, Lb, Lc) of the bank (B);
- means for adjusting the emission frequencies of the tunable lasers;
- an optical filter (MR; MO+MR) having a plurality of resonant frequencies, two successive resonant frequencies being separated by the determined spectral interval, the optical filter (MR; MO+MR) being arranged optically downstream of the bank (B) of tunable lasers, the optical filter (MR; MO+MR) being provided with a device for adjusting (H) the plurality of resonant frequencies;
- a photodetector (PD) arranged optically downstream of the optical filter (MR) in order to establish a signal (V) representative of the multispectral light radiation transmitted through the filter (MR; MO+MR);
- a modulator (M) associated with means for adjusting the emission frequencies of the tunable lasers, the modulator (M) being designed to generate a modulation signal (Vd; Vda, Vdb, Vdc) and to modulate the emission frequency of the light radiation emitted by at least one tunable laser (La, Lb, Lc) of the bank (B);
- a locking device (R) connected to the means for adjusting the emission frequency of the tunable lasers and connected to the device for adjusting (H) the plurality of resonant frequencies, the locking device (R) being designed to process the signal representative of the multispectral radiation (V) and to lock the emission frequencies of the tunable lasers to the resonant frequencies of the filter (MR; MO+MR).

2. Laser source (1) according to the preceding claim, comprising an optical mixer (MO), which is associated with the bank (B) of tunable lasers, for combining the light radiations emitted by the tunable lasers of the bank and for providing the multispectral light radiation (RLM) to the filter (MR).

3. Laser source (1) according to either of the preceding claims, wherein the optical filter (MR) is a micro ring resonator.

4. Laser source (1) according to any of the preceding claims, wherein the device for adjusting (H) the plurality of resonant frequencies is a heater.

5. Laser source (1) according to any of the preceding claims, wherein the means for adjusting the emission frequency of the tunable lasers are selected from the list consisting of: a current source, a heater, a free carrier injection/depletion device.

6. Laser source (1) according to any of the preceding claims, wherein the lasers (La, Lb, Lc) of the bank (B) of tunable lasers are distributed feedback lasers or distributed Bragg reflector lasers.

7. Laser source (1) according to any of the preceding claims, wherein the locking device (R) is designed to control the modulator (M) and to select, by means of a selection signal (Sel), the tunable laser (La, Lb, Lc) to which the modulation signal (Vd) is applied.

8. Laser source (1) according to any of claims 1 to 6, wherein the modulator (M) generates a plurality of modulation signals (Vda, Vdb, Vdc) distinct from one another, the modulation signals (Vda, Vdb, Vdc) being applied to the tunable lasers (La, Lb, Lc).

9. Laser source (1) according to any of the preceding claims, wherein the modulator (M) is designed to produce a sinusoidal modulation signal (Vd; Vda, Vdb, Vdc) having a modulation frequency (Fd; Fda, Fdb, Fdc).

10. Laser source (1) according to the preceding claim, wherein the locking device (R) is designed to establish a measurement representative of the power present in a second harmonic and/or in a main component and/or a measurement representative of the phase of the main component of the modulation frequency (Fd; Fda, Fdb, Fdc) of the signal representative of the multispectral radiation (V).

11. Laser source (1) according to any of the preceding claims, wherein the bank (B) of tunable lasers and the optical filter (MR) are integrated on/in the same substrate of a photonic chip.

12. Laser source (1) according to the preceding claim, wherein the temperature drift coefficient of tunable laser emission frequencies and the temperature drift coefficient of resonant frequencies are identical to within 10%.

13. Method for using a laser source (1) according to any of the preceding claims, the method being implemented by the locking device (R) and comprising:
- a control phase for activating the device for adjusting (H) the plurality of resonant frequencies of the optical filter (MR);
- a locking phase for locking the emission frequency of the light radiation of the selected tunable laser to a resonant frequency of the filter.

14. Usage method according to the preceding claim, wherein the locking phase is actuated after the control phase.
